# Europäisches Patentamt
# European Patent Office
# Office européen des brevets

(19)

(11) Veröffentlichungsnummer : **0 142 119**
**B1**

(12) **EUROPÄISCHE PATENTSCHRIFT**

(45) Veröffentlichungstag der Patentschrift :
**30.12.86**

(51) Int. Cl.⁴ : **G 01 R   1/073, H 05 K   1/14**

(21) Anmeldenummer : **84113375.4**

(22) Anmeldetag : **06.11.84**

(54) Anordnung zur Veränderung der Kontaktabstände eines Kontaktfeldrasters an einem Leiterplattenprüfgerät.

(30) Priorität : **07.11.83 DE 3340179**

(43) Veröffentlichungstag der Anmeldung :
**22.05.85 Patentblatt 85/21**

(45) Bekanntmachung des Hinweises auf die Patenterteilung : **30.12.86 Patentblatt 86/52**

(84) Benannte Vertragsstaaten :
**AT BE CH DE FR GB IT LI LU NL SE**

(56) Entgegenhaltungen :
**US-A- 3 963 986**
**US-A- 4 250 536** ·
**IBM TECHNICAL DISCLOSURE BULLETIN, Band 17, Nr. 3, August 1974, Seiten 930-931, New York, US; R. BOVE u.a.: "Space transformer for use in an electronic test system"**
**IBM TECHNICAL DISCLOSURE BULLETIN, Band 16, Nr. 8, Januar 1974, Seiten 2724-2727, New York, US; A. PERLMANN u.a.: "AC space transformer for multi-pin systems"**

(73) Patentinhaber : **MANIA Elektronik Automatisation Entwicklung und Gerätebau GmbH**
**Hauptstrasse 86**
**D-6384 Schmitten 2 (DE)**

**Mang, Paul**
**Weilbergstrasse 4**
**D-6384 Schmitten 3 (DE)**

(72) Erfinder : **Driller, Hubert, Dipl.-Phys.**
**Altkönigstrasse 11**
**D-6384 Schmitten 3 (DE)**
Erfinder : **Mang, Paul**
**Weilbergstrasse 4**
**D-6384 Schmitten 3 (DE)**

(74) Vertreter : **Ruschke, Hans Edvard et al**
**Patentanwälte Dipl.-Ing. Olaf Ruschke Dipl.-Ing. Hans E. Ruschke Dipl.-Ing. Jürgen Rost Dipl.-Chem. Dr. U. Rotter Pienzenauerstrasse 2**
**D-8000 München 80 (DE)**

## Beschreibung

Automatische Leiterplattenprüfgeräte weisen ein Kontaktpunktraster auf, welches über geeignete Adapter, wie sie beispielsweise in der DE-OS-29 33 862 beschrieben sind, mit der zu prüfenden Leiterplatte verbunden werden. Ein Kontaktpunktraster eines üblichen Leiterplattenprüfgerätes kann beispielsweise 256 Kontaktpunkte in Längs- und Querrichtung haben, d. h. es handelt sich um ein Kontaktfeld mit insgesamt 65 536 Kontaktpunkten. Diese haben sowohl in der W- als auch in der Y-Richtung einen bestimmten Abstand voneinander, d. h. es ist in etwa eine Kontaktpunktdichte vorgesehen, wie sie üblicherweise bei herkömmlichen Leiterplatten angetroffen wird, die mit der Leiterplattenprüfvorrichtung zu testen sind. Dieser Abstand beträgt in der Regel 1/10", also 2,54 mm.

Nun wird es häufiger vorkommen, daß man mit dem Leiterplattenprüfgerät der oben erwähnten Kontaktdichte Leiterplatten mit einer wesentlich höheren Kontaktdichte prüfen will. Dies ist insbesondere bei Keramik-Leiterplatten der Fall, die üblicherweise einen Kontaktpunktabstand von 1/20" oder 1,27 mm aufweisen. Eine Anpassung des von dem Leiterplattenprüfgerät her gegebenen, relativ weitmaschigen Kontaktpunktrasters an dieses dichte Raster mit Hilfe eines üblichen Adapters unter Verwendung von biegsamen und teleskopisch federnden Kontaktstiften, etwa nach der erwähnten DE-OS-29 33 862, führt zu erheblichen Schwierigkeiten, weil allein durch die Baugröße dieser Kontaktstifte und die zu überbrückende Entfernung eine gewisse Kontaktdichte nicht mehr unterschritten werden kann — jedenfalls nicht ohne einen ganz erheblichen Aufwand bei der Herstellung besonders dünner langer Kontaktstifte.

In der DE-OS-25 25 166 ist eine Kontakt-Sondenvorrichtung beschrieben, bei der es darum geht, die Kontaktdichte an einer Prüfmaschine auf die Kontaktdichte einer zu prüfenden integrierten Schaltung räumlich zu transformieren. Das Kontakt-Ausgangsraster ist auf mehreren konzentrischen Kreisen angeordnet und über in mehreren Ebenen nach innen geführte Koaxialkabel mit dem Kontakt-Entraster verbunden, welches dadurch hergestellt wird, daß die Innenleiter der Koaxialkabel in der Mitte der Transformationseinrichtung durch ein nicht leitendes Formstück mit achsparallelen Bohrungen geführt werden, deren Abstand voneinander dem gewünschten, sehr dichten Kontaktmuster entspricht. Da diese räumliche Transformationseinrichtung (Adapter) für die Prüfung von integrierten Schaltungen und nicht etwa Leiterplatten ausgelegt ist, kommt es angesichts der sehr hohen Schaltgeschwindigkeiten bei der Prüfung solcher integrierter Schaltungen darauf an, daß dieser Adapter für alle Verbindungen eine konstante Impedanz, nahezu keine Unstetigkeitsstellen und ein Minimum an gegenseitiger Kopplung aufweist. Es liegt auf der Hand, daß ein solcher Adapter zur Prüfung der elektrischen Eigenschaften eines IC wegen der notwendigen Präzision nur unter hohen Kosten herzustellen ist, was für die Prüfung von Leiterplatten nicht notwendig ist ; diese werden nur im Hinblick darauf geprüft, ob eventuell mehr oder weniger elektrische Verbindungen als beabsichtigt vorgesehen sind.

Es ist daher die der vorliegenden Erfindung zugrundeliegende Aufgabe, einen Adapter zu schaffen, welcher mit einfachen Mitteln eine erhebliche Veränderung der Kontaktdichte eines vorgegebenen Kontaktrasters an einem Leiterplattenprüfgerät ermöglicht. Beispielsweise soll der Abstand der Kontaktpunkte in X- und Y-Richtung von einer Ausgangsgröße 1/10" = 2,54 mm auf 1/20" = 1,27 mm verringert werden.

Diese Aufgabe wird in überraschend einfacher Weise durch die im Hauptanspruch angegebene Merkmalskombination gelöst.

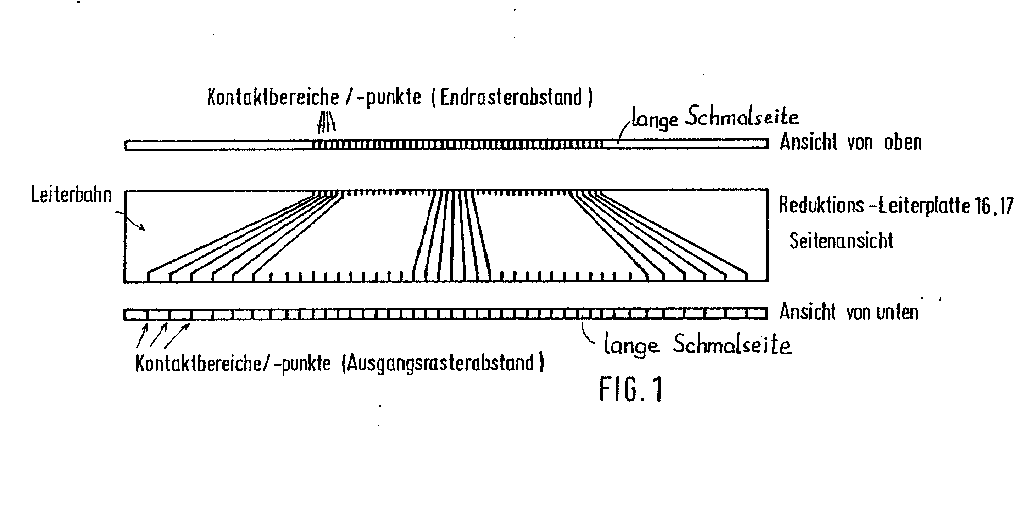

Der Kernpunkt der Erfindung liegt in der Verwendung von dünnen langgestreckten Leiterplatten, die auf den einander abgewandten langen Schmalseiten mit separaten Kontaktbereichen oder -punkten versehen sind, die auf der einen Seite einen Abstand voneinander haben, der dem Ausgangsraster entspricht, also im angegebenen Beispiel 1/10" oder 2,54 mm, während sie auf der anderen Seite einen Abstand entsprechend dem verkleinerten Raster haben, als 1/20" oder 1,27 mm. Jedem Kontaktbereich oder -punkt auf der einen langen Schmalseite ist ein Kontaktbereich oder -punkt auf der gegenüberliegenden langen Schmalseite der Leiterplatte zugeordnet, wobei die einander entsprechenden Punkte mit Hilfe von Leiterbahnen nach Art einer gedruckten Schaltung auf der Deck- und/oder Bodenfläche der Leiterplatte elektrisch leitend miteinander verbunden sind. Die auf den beiden langen Schmalseiten der Leiterplatte angeordneten Kontaktpunkte sind also jeweils miteinander durch auf der Oberfläche der Leiterplatte angeordnete Leiterbahnen elektrisch miteinander verbunden. Dieses als « Reduktions-Leiterplatte » zu bezeichnende Bauelement ist sowohl in Seitenansicht als auch in einer Ansicht von oben bzw. unten in Fig. 1 dargestellt. Um die Reduzierung eines weiten Prüfkontaktrasters mit beispielsweise 256 × 256 Kontaktpunkten zu einem dichten Kontaktpunktraster zu bewerkstelligen ist es lediglich notwendig, in einer ersten « Ebene » 256 derartige Reduktions-Leiterplatten mit jeweils 256 Kontaktbereichen oder -punkten auf den langen Schmalseiten jeweils hochkant und parallel zueinander auf dem Ausgangsraster anzuordnen. Soweit diese Leiterplatten in Y-Richtung verlaufend angeordnet sind, erfolgt also zunächst in der ersten « Ebene » der Reduktions-Leiterplatten eine Reduzierung des Kontaktabstandes des Grundrasters in der Y-Richtung. Anschließend müssen noch in einer zweiten darüber angeordneten « Ebene » jeweils 256 parallel zueinander angeordnete Reduktions-Leiterplatten in der X-

Richtung angeordnet werden, und zwar ausgehend von dem bereits in der Y-Richtung reduzierten Kontaktabstand. Das Ergebnis ist ein sowohl in der X-Richtung als auch in der Y-Richtung stark reduzierter Kontaktabstand. Das reduzierte Prüfkontaktfeld wird im Prinzip von den einen kleinen Abstand voneinander aufweisenden Kontaktpunkten auf den langen (oberen) Schmalseiten der in der oberen Ebene angeordneten Leiterplatten gebildet, welche einen seitlichen Abstand voneinander haben, der dem Abstand der zuletzt erwähnten Kontaktpunkte entspricht.

Allein zur Sicherung eines guten elektrischen Kontaktes zwischen den jeweiligen Kontaktpunkten der in zwei « Ebenen » oder Lagen übereinander hochkant angeordneten Leiterplatten ist es notwendig, zwischen den beiden Ebenen noch eine beispielsweise aus Epoxid oder einem anderen Kunststoff hergestellte Führungsplatte für teleskopartig federnde Verbindungsstifte vorzusehen, die mit ihrem oberen bzw. unteren Ende jeweils die unteren bzw. oberen Kontaktbereiche oder -punkte der Leiterplatten in der oberen bzw. unteren Ebene kontaktieren.

In ähnlicher Weise muß — allein zur Sicherstellung eines guten Kontaktes — zwischen den unteren Kontaktpunkten der unteren Leiterplattenebene/anordnung ein Zwischenadapter mit federnden Teleskopstiften vorgesehen sein, die den Kontakt zwischen den Leiterplatten und dem Ausgangsraster des Leiterplattenprüfgerätes herstellen.

Die Notwendigkeit dieser teleskopartig federnden Kontaktstifte liegt auf der Hand wenn man bedenkt, daß bei dem angeführten Beispiel von 256 Kontakten jeweils in der X- und Y-Richtung sichergestellt sein muß, daß alle 65 536 Kontakte tatsächlich Kontakt haben. Dies geschieht in der Praxis dadurch, daß durch geeignete, beispielsweise hydraulische Anpreßvorrichtungen ein ganz erheblicher Kontaktdruck auf die gesamte Anordnung aufgebracht wird.

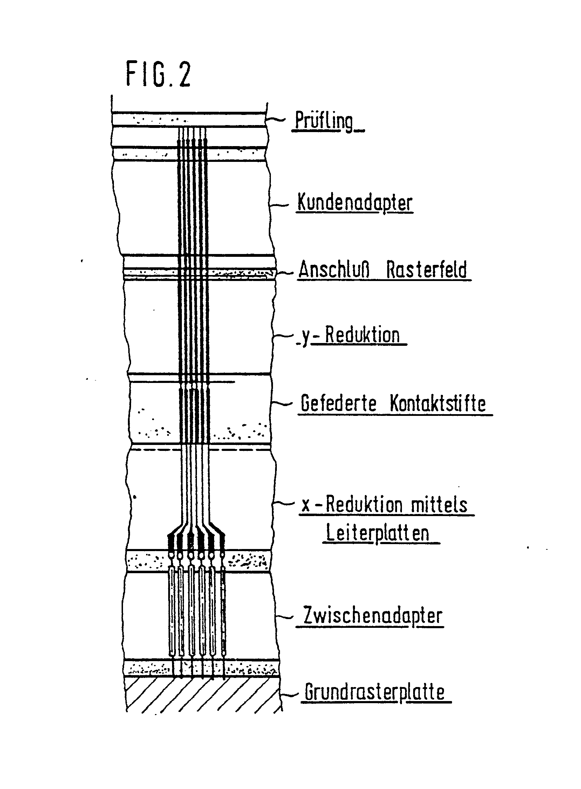

In der Figur 2 ist der grundsätzliche Aufbau dieser Anordnung (auch « Reduktions-Adapter » genannt) ausgehend von der Grundrasterplatte eines Leiterplattenprüfgerätes gezeigt : Ausgehend von dieser Grundrasterplatte ist zunächst (wie erwähnt) ein Zwischenadapter mit teleskopartig federnden Kontaktstiften vorgesehen. Darüber erfolgt die Reduktion in X-Richtung mit Hilfe von (parallel zur Zeichenebene) hochkant angeordneten, langgestreckten Leiterplatten. Darüber ist die bereits erwähnte Epoxid-Führungsplatte mit den gefederten Kontaktstiften vorgesehen, die die Verbindung zwischen der X-Reduktionsebene und der Y-Reduktionsebene schaffen. Die Reduktion des Kontaktabstandes in der Y-Richtung erfolgt dann wie in Fig. 2 dargestellt mit Hilfe der Leiterplatten, die dort als senkrecht zur Zeichenebene verlaufend angenommen werden. Durch die oberen Schmalseiten der Leiterplatten in der Y-Reduktionsebene wird das reduzierte Anschluß-Rasterfeld gebildet, welches das nunmehr reduzierte Kontaktpunkt-Rasterfeld des Leiterplattenprüfgerätes bildet.

Auf dieses Anschlußrasterfeld kann in bekannter Weise ein spezieller Kundenadapter aufgebracht werden, der die Verbindung zu dem Prüfling, d. h. der zu prüfenden Leiterplatte schafft.

Ein Ausführungsbeispiel der Erfindung wird im nachfolgenden unter Bezugnahme auf die beigefügten Zeichnungen beschrieben. In diesen zeigt :

Figur 1 die Reduktions-Leiterplatte in einer Seitenansicht sowie eine Ansicht von oben bzw. unten ;

Figur 2 den grundsätzlichen Aufbau des Reduktionsadapters im Zusammenhang mit der Grundrasterplatte des Leiterplattenprüfgerätes und dem auf einem speziellen Kundenadapter angeordneten Prüfling in Form der zu prüfenden Leiterplatte ;

Figur 3 eine Seitenansicht einer Ausführungsform des Reduktionsadapters ;

Figur 4 eine Draufsicht auf den Adapter ;

Figur 5 einen Schnitt längs Linie B-B aus Fig. 4 ; und

Figur 6 einen Schnitt längs Linie A-A aus Fig. 4.

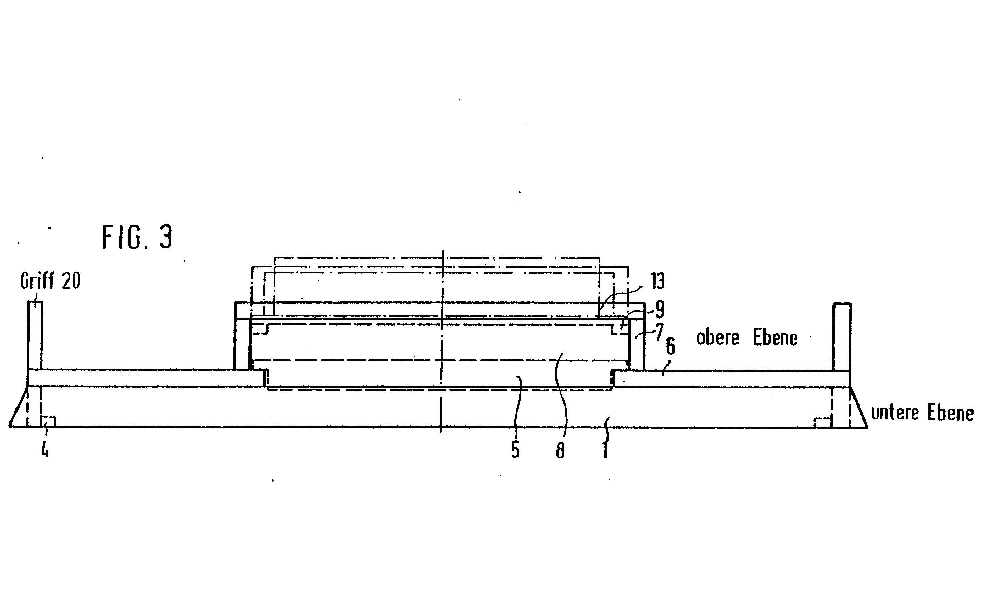

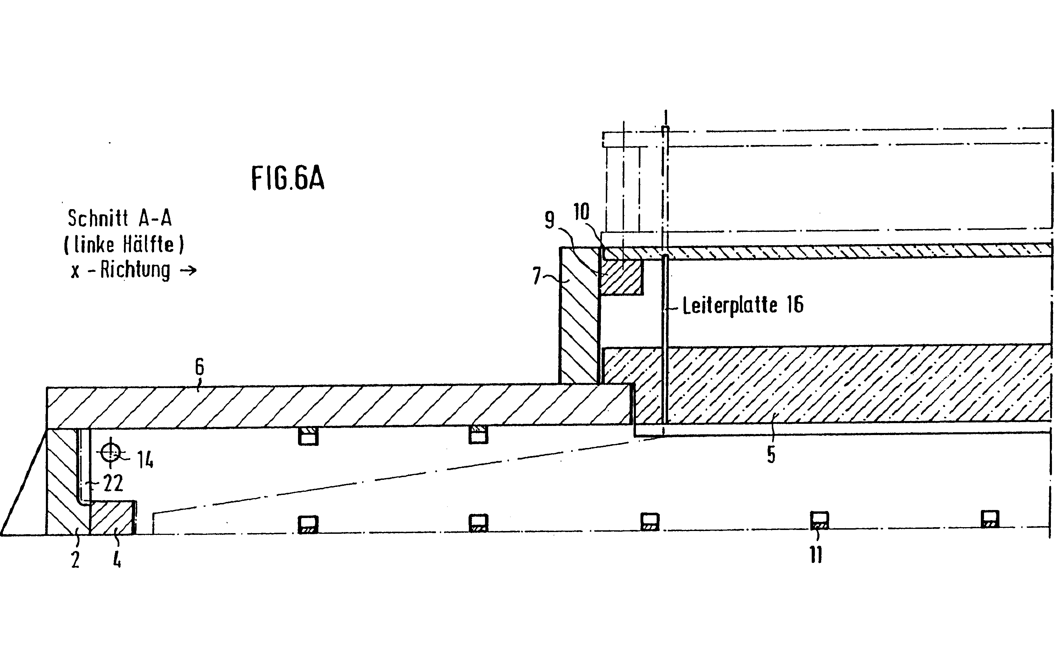

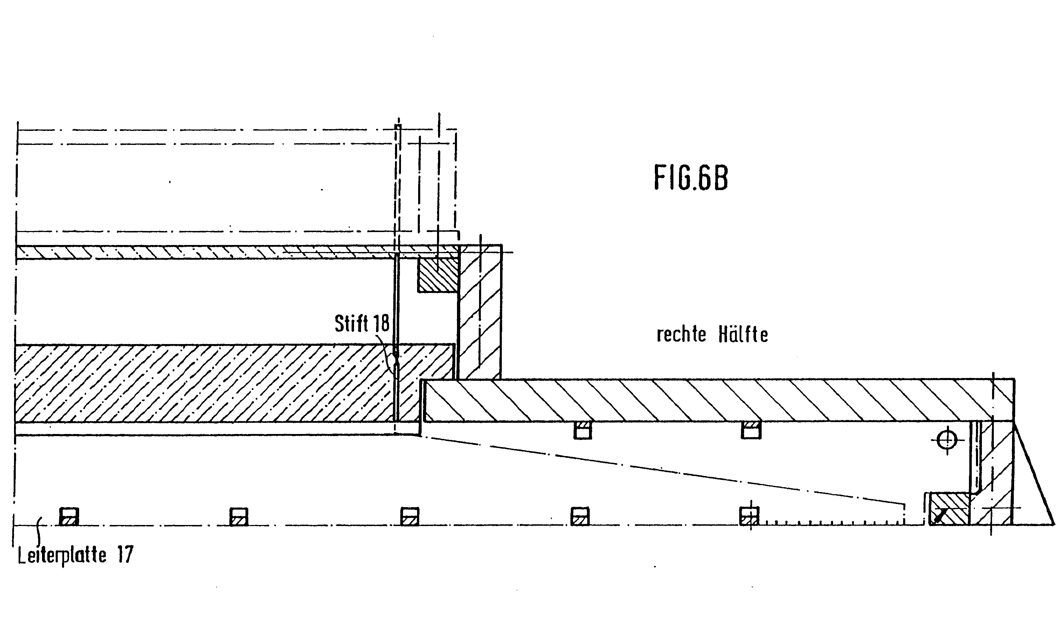

In einem flachen quadratischen Rahmen bestehend aus Rahmen-Seitenteilen 1 und 2 sind in einer unteren Ebene (vergl. Fig. 3) eine große Anzahl von rechteckigen hochkant angeordneten, parallel zueinander verlaufenden Reduktions-Leiterplatten gemäß Fig. 1 angeordnet, von denen bei 17 eine angedeutet ist. Soweit es sich bei dem Ausführungsbeispiel um ein Grundraster mit 256 × 256 Kontakten handelt, sind in der unteren Ebene 256 derartiger Leiterplatten 17 parallel zueinander in dem quadratischen Rahmen aus Seitenteilen 1, 2 untergebracht. Die einzelnen Leiterplatten 17 werden wie bei 22 in Fig. 6 angedeutet durch in den Seitenteilen 2 vorgesehene senkrechte Nuten 22 voneinander auf Abstand gehalten. Da die Leiterplatten 17 naturgemäß sehr dünn sein müssen und eine beachtliche Länge haben, kann es zur Vermeidung von Verwerfungen an der Unterseite der unteren Ebene (Fig. 3) der Leiterplatten 17 vorteilhaft sein, mehrere Positionierstangen 11 vorzusehen, die quer zu den Leiterplatten 17 verlaufen und durch entsprechend angeordnete Nuten die Leiterplatten 17 in ihrer vorgesehenen Stellung fixieren. Dadurch würden einige Kontaktpunkte des Ausgangsrasters unberücksichtigt bleiben, was aber für die prinzipielle Lösung unerheblich ist : Das reduzierte Kontaktfeldraster hätte dann einige Kontaktpunkte weniger.

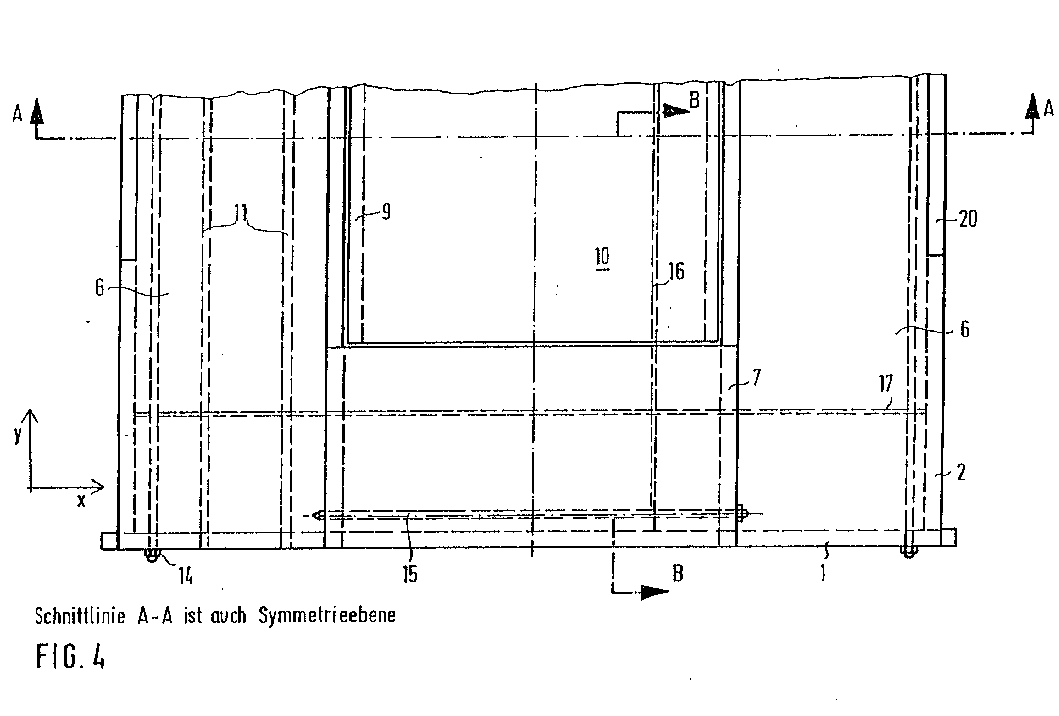

Aufgrund der in der unteren Ebene angeordneten Reduktions-Leiterplatten 17 ergibt sich an der Oberseite der unteren Ebene ein in X-Richtung reduziertes, in Y-Richtung jedoch noch unverändertes Kontaktfeld. Dieses entspricht in etwa den äußeren Abmessungen, wie sie durch die oberen Rahmen-Seitenteile 7 sowie die Seitenteile 1 in Fig. 4 begrenzt werden. Dieses rechteckige Kontaktfeld wird im dargestellten Ausführungsbeispiel überdeckt von einer entsprechend gestalteten, rechteckigen Epoxid-Führungsplatte 5, in der senkrechte Bohrungen in Übereinstimmung mit den Kontaktpunkten in dem darunter befindlichen rechteckigen Kontaktfeld angeordnet sind.

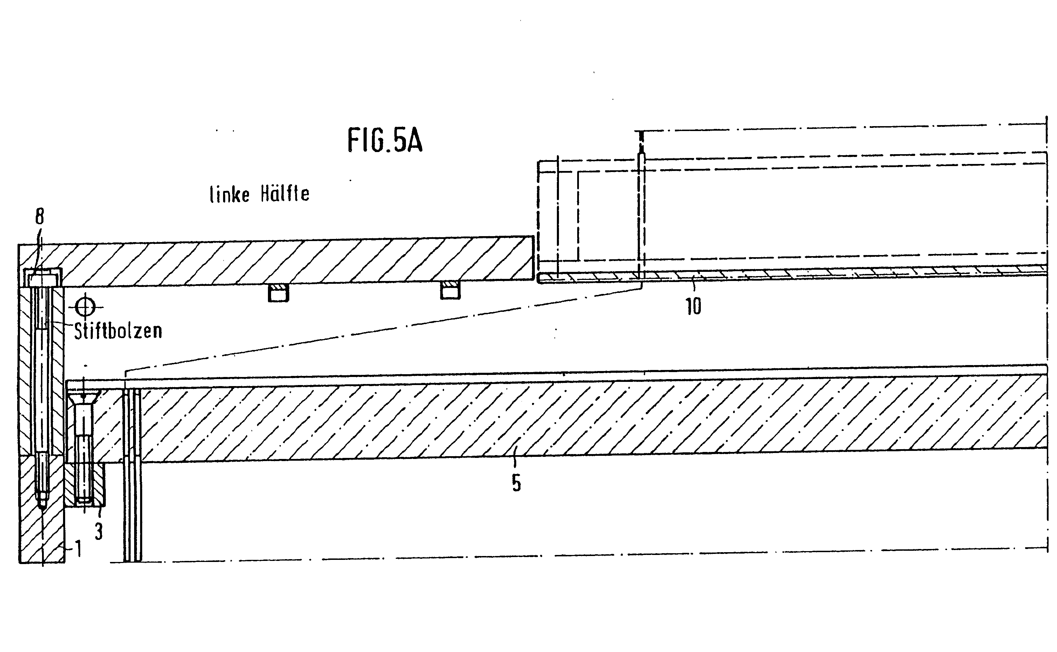

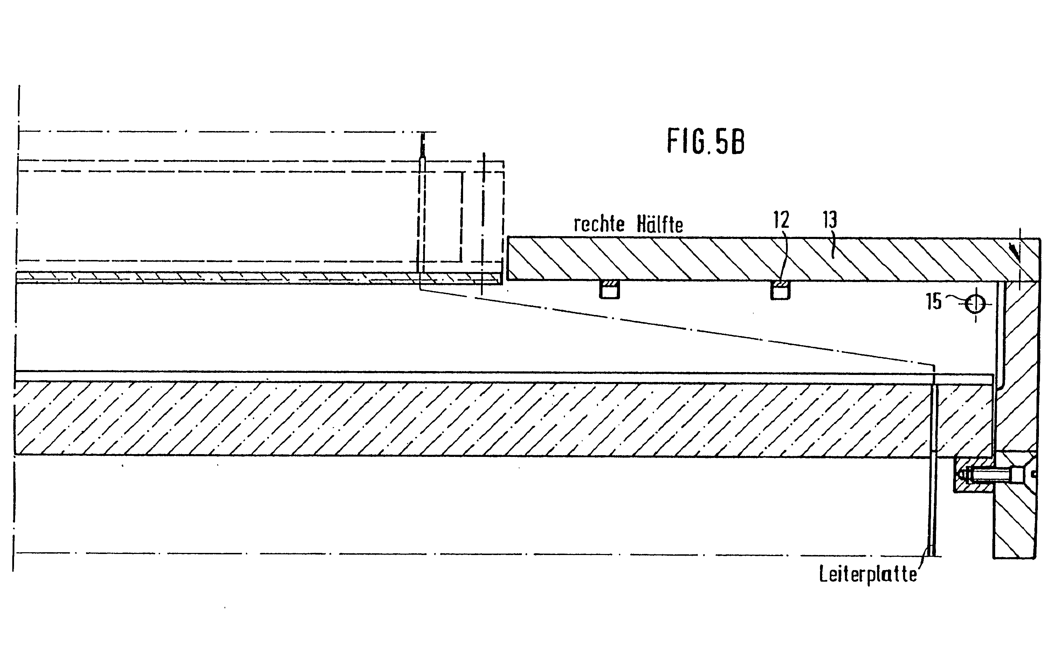

Diese Bohrungen dienen zur Aufnahme von teleskopartig gefederten Kontaktstiften 18, die die Verbindung zwischen den unteren Reduktionsleiterplatten 17 und den oberen Reduktionsleiterplatten 16 schaffen. Die Führungsplatte 5 ist, wie sich dies aus den Figuren 5 und 6 ergibt, an ihrer Unterseite in X-Richtung und an ihrer Oberseite in Y-Richtung genutet, wobei diese Nuten zur Aufnahme bzw. Führung der oberen langen Schmalseiten der Leiterplatten 17 in der unteren Ebene bzw. zur Führung bzw. Aufnahme der unteren langen Schmalseiten der Leiterplatten 16 der oberen Ebene vorgesehen sind.

Die Leiterplatten 16 der oberen Ebene oder Lage sind grundsätzlich in der gleichen Weise ausgebildet wie dies im Zusammenhang mit der Fig. 1 beschrieben wurde, d. h. die Leiterplatten 16 reduzieren den Abstand der Kontaktpunkte in der Y-Richtung ohne den Abstand in der X-Richtung zu verändern, da dieses schon in der unteren Ebene geschehen ist, wie dies weiter oben beschrieben wurde. Das sich dadurch ergebende reduzierte Kontaktfeldraster wird durch eine Rasterfeld-Anschlußplatte 10 abgedeckt, die an ihrer Unterseite ebenfalls in Y-Richtung leicht genutet ist, um auch hier eine stabile Führung bzw. Halterung der Leiterplatten 16 vorzusehen. Die Rasterfeld-Anschlußplatte 10 ist mit entsprechend den Kontaktbereichen/punkten mit senkrechten Bohrungen versehen, damit in bekannter Weise ein Kundenadapter mit seinen teleskopartig federnden Kontaktstiften an das reduzierte Kontaktfeldraster angeschlossen werden kann. Ein solcher Kundenadapter ist beispielsweise in den Figuren 5 und 6 mit gestrichelten Linien angedeutet.

Der beschriebene Adapter wird durch auf der unteren Ebene aufliegende seitliche Abdeckplatten 6 bzw. durch auf der oberen Ebene aufliegende Abdeckplatten 13 vervollständigt. Auch die Leiterplatten 16 der oberen Ebene können mit Hilfe von in X-Richtung verlaufenden oberen Positionierstangen 12 gegen Verwerfungen und Ausbeulungen gesichert werden (Fig. 5). Der kastenförmige Rahmen wird wie bei 14 und 15 angedeutet durch geeignete Spannstangen zusammengehalten. Aus Fig. 5 geht im übrigen hervor, daß die Führungsplatte 5 mit Gewindeleisten verschraubt ist und daß die unteren seitlichen Rahmenteile 1 mit oberen seitlichen Rahmenteilen 8 in geeigneter Weise verschraubt sind, um ein zusammenhängendes Ganzes zu bilden. Auf diese einfachen konstruktiven Details wird im vorliegenden Rahmen nicht näher eingegangen.

Um den Reduktions-Adapter ohne Schwierigkeiten handhaben zu können, sind geeignete Griffe 20 am Rahmen befestigt, wie dies in den Figuren 3 und 4 angedeutet ist.

Es liegt auf der Hand, daß das oben beschriebene Prinzip zur Erhöhung der Kontaktdichte auch zur Verringerung derselben verwendet werden kann.

**Patentansprüche**

1. Anordnung an einem Leiterplattenprüfgerät zur Anpassung der Abstände von Kontakten, die in einem Kontaktfeld entsprechend einem Ausgangsraster angeordnet sind, an die Abstände von Kontakten, die entsprechend einem Endraster angeordnet sind, dadurch gekennzeichnet,

a) daß eine Anzahl von Leiterplatten mit je zwei einander gegenüberliegenden parallelen langen Schmalseiten vorgesehen ist, die jeweils eine Reihe von Kontaktpunkten tragen, deren Abstand voneinander auf der einen langen Schmalseite dem Kontaktabstand des Ausgangsrasters und auf der anderen langen Schmalseite dem Kontaktabstand des Endrasters entspricht und die einander zugeordneten Kontaktpunkte auf den beiden langen Schmalseiten durch auf der Leiterplatte angeordnete Leiterbahnen elektrisch miteinander verbunden sind,

b) daß der erste Teil dieser Leiterplatten in einer ersten Ebene hochkant parallel zueinander mit ihren im Ausgangsrastermaß beabstandeten Kontaktpunkten in Längsrichtung auf dem Kontaktfeldraster aufliegend angeordnet sind,

c) und daß der zweite Teil dieser Leiterplatten in einer über der ersten Ebene angeordneten zweiten Ebene hochkant parallel zueinander mit ihren im Ausgangsrastermaß beabstandeten Kontaktpunkten in Querrichtung zum ersten Teil der Leiterplatten auf den im Endrastermaß beabstandeten Kontaktpunkten des ersten Teils der Leiterplatten aufliegend angeordnet sind.

2. Anordnung nach Anspruch 1, dadurch gekennzeichnet, daß die einander zugeordneten Kontaktpunkte der einander zugewandten Kontaktpunktraster der zwei Leiterplatten-Ebenen (16, 17) jeweils über teleskopisch federnde Kontaktstifte (18) miteinander verbunden sind, welche von einer Führungsplatte (5) gehaltert sind.

3. Anordnung nach Anspruch 2, dadurch gekennzeichnet, daß die Führungsplatte (5) auf der den beiden Leiterplatten-Ebenen (17, 16) zugewandten Deck- bzw. Bodenfläche in Querrichtung bzw. Längsrichtung mit parallelen Nuten versehen sind zur Aufnahme und Führung der jeweiligen langen Leiterplatten-Schmalseiten.

4. Anordnung nach einem der voranstehenden Ansprüche, dadurch gekennzeichnet, daß auf den in Gebrauchslage des Leiterplattenprüfgeräts oberen langen Schmalseiten des zweiten Teils der Leiterplatten (16) eine in Richtung derselben mit Nuten zur Aufnahme und Halterung dieser langen Schmalseiten versehene Rasterfeld-Anschlußplatte (10) angeordnet ist, die mit Bohrungen entsprechend den auf diesen langen Schmalseiten angeordneten Kontaktpunkten versehen ist, die das Endraster ausbilden.

5. Anordnung nach einem der voranstehenden Ansprüche, dadurch gekennzeichnet, daß die Leiterplatten (17) in der ersten Ebene von senkrecht dazu verlaufenden Positionierstangen (11, 12) gegen Ausbeulungen gesichert sind.

## Claims

1. Assembly in printed circuit board testing apparatus for adapting the pitch of contacts arranged on a basic grid to the spacing between contacts arranged in accordance with a target grid, characterized by

a) a plurality of printed circuit cards each having two opposite parallel long narrow side edges having thereon a row of contacts of which the spacing on one long narrow side edge corresponds to the pitch of said basic grid and of which the spacing on the other long side edge corresponds to the pitch of the target grid, with associated ones of the contacts on both long narrow side edges being interconnected electrically by conductors on the circuit card,

b) a first portion of said circuit cards being disposed in a first plane in an up-edge parallel relationship and with their contacts spaced according to the basic grid lying on the contact array grid in the longitudinal direction, and

c) a second portion of said circuit cards being disposed in an up-edge parallel relationship in a second plane above said first plane, with the contacts spaced according to the basic grid pitch lying transversely to the first portion of the circuit cards on the contacts of the circuit cards of said first portion which are spaced according to the target grid.

2. Assembly as in claim 1, characterized by the associated ones of the contacts of the contact arrays mutually facing each other on the two printed circuit board planes (16, 17) being interconnected by telescoping resilient contact pins (18) held by a guide plate (5).

3. Assembly as in claim 2, characterized by guide plate (5) having therein on the top and bottom surfaces facing the two circuit board planes (17, 16) parallel grooves extending in the transverse and in the longitudinal directions to receive and guide respective ones of the long narrow side edges of said printed circuit cards.

4. Assembly as in any one of the preceding claims, characterized by an array connection plate (10) provided with grooves for receiving and holding by their long narrow edges circuit cards (16) of said second portion which are at the top in the operating position of the printed circuit board testing apparatus, and by said array connection plate having therethrough bores in accordance with the contacts forming the target grid and provided on the aforesaid long narrow side edges.

5. Assembly as in any one of the preceding claims, characterized by circuit cards (17) being secured against warpage in the first plane by positioning bars (11, 12) perpendicular thereto.

## Revendications

1. Agencement sur un appareil à vérifier des circuits imprimés pour adapter les écartements de contacts qui sont disposés en un champ de contacts conformément à une grille initiale, aux écartements de contacts qui sont disposés suivant une grille finale, caractérisé en ce que

a) plusieurs circuits imprimés sont prévus avec chacun deux longs petits côtés parallèles mutuellement opposés, qui portent chacun une série de points de contact, dont l'écartement mutuel correspond sur l'un des longs petits côtés à l'écartement des contacts de la grille initiale et sur l'autre long petit côté à l'écartement des contacts de la grille finale, et les points de contacts associés mutuellement sur les deux longs petits côtés sont reliés électriquement entre eux par des rubans conducteurs situés sur le circuit imprimé,

b) la première partie de ces circuits imprimés sont agencés dans un premier plan sur chant parallèlement entre eux, avec leurs points de contact écartés à la dimension de la grille initiale suivant la direction longitudinale reposant sur la grille de champ de contacts,

c) et la seconde partie de ces circuits imprimés sont agencés dans un second plan situé au-dessus du premier plan sur chant parallèlement entre elles, avec leurs points de contact écartés à la dimension de la grille initiale reposant suivant la direction transversale par rapport à la première partie des circuits imprimés, sur les points de contact écartés à la dimension de la grille finale, de la première partie des circuits imprimés.

2. Agencement suivant la revendication 1, caractérisé en ce que les points de contact associés mutuellement des grilles de points de contacts dirigées l'une vers l'autre des deux plans de circuits imprimés (16, 17) sont chacun reliés entre eux par des broches de contact élastiques télescopiques (18) qui sont maintenues par une plaque de guidage (5).

3. Agencement suivant la revendication 2, caractérisé en ce que la plaque de guidage (5) est dotée sur les surfaces supérieure et inférieure dirigées vers les deux plans de circuits imprimés (17, 16), suivant la direction transversale et la direction longitudinale, de rainures parallèles pour la réception et le guidage des longs petits côtés de circuits imprimés concernés.

4. Agencement suivant une des revendications précédentes, caractérisé en ce que sur les longs petits côtés supérieurs dans la position d'utilisation de l'appareil de vérification de circuits imprimés, de la seconde partie des circuits imprimés (16), est agencée une plaque de connexion de champ de grille (10) dotée dans la direction de ceux-ci de rainures pour la réception et le guidage de ces longs petits côtés, qui est dotée d'alésages correspondant aux points de contacts situés sur ces longs petits côtés, qui forment la grille finale.

5. Agencement suivant une des revendications précédentes, caractérisé en ce que les circuits imprimés (17) dans le premier plan sont assurés contre des bombements par des tiges de positionnement (11, 12) s'étendant perpendiculairement à ceux-ci.

Kontaktbereiche / -punkte ( Endrasterabstand )

lange Schmalseite

Ansicht von oben

Leiterbahn

Reduktions –Leiterplatte 16,17

Seitenansicht

Ansicht von unten

lange Schmalseite

Kontaktbereiche/-punkte (Ausgangsrasterabstand )

FIG. 1

0 142 119

# FIG. 2

Prüfling

Kundenadapter

Anschluß Rasterfeld

y - Reduktion

Gefederte Kontaktstifte

x - Reduktion mittels Leiterplatten

Zwischenadapter

Grundrasterplatte

# FIG. 3

Griff 20

13
9
7
6    obere Ebene

untere Ebene

4

5    8    1

3

0 142 119

Schnittlinie A-A ist auch Symmetrieebene

FIG. 4

0 142 119

# FIG.5A

linke Hälfte

8

Stiftbolzen

10

5

3

1

FIG.5B

rechte Hälfte

Leiterplatte

13

12

15

6

FIG.6A

Schnitt A-A
(linke Hälfte)
x -Richtung →

Leiterplatte 16

FIG.6B

rechte Hälfte

Stift 18

Leiterplatte 17

0 142 119